Europäisches Patentamt

European Patent Office

Office européen des brevets

(11) Publication number: **0 077 813**
**B1**

## (12) EUROPEAN PATENT SPECIFICATION

(45) Date of publication of patent specification: **05.02.86**

(21) Application number: **82901672.4**

(22) Date of filing: **15.04.82**

(86) International application number:
**PCT/US82/00472**

(87) International publication number:
**WO 82/03948 11.11.82 Gazette 82/27**

(51) Int. Cl.⁴: **H 01 L 29/04, H 01 L 23/48,
H 01 L 29/46, H 01 L 29/54**

(54) **LOW RESISTIVITY COMPOSITE METALLIZATION FOR SEMICONDUCTOR DEVICES AND METHOD THEREFOR.**

(30) Priority: **04.05.81 US 260667**

(43) Date of publication of application:
**04.05.83 Bulletin 83/18**

(45) Publication of the grant of the patent:
**05.02.86 Bulletin 86/06**

(84) Designated Contracting States:
**DE FR GB NL**

(56) References cited:
**US-A-3 581 161**
**US-A-3 632 436**
**US-A-3 754 168**
**US-A-4 042 953**
**US-A-4 112 196**
**US-A-4 128 670**
**US-A-4 227 944**
**US-A-4 276 557**
**US-A-4 329 706**

(73) Proprietor: **MOTOROLA, INC.**
**1303 East Algonquin Road**
**Schaumburg, Illinois 60196 (US)**

(72) Inventor: **ASPIN, Carlton H.**
**1940 E. Richards Drive**
**Tempe, AZ 85282 (US)**
Inventor: **LO, Wei Jen**
**19 Glorietta West**
**Irvine, CA 92714 (US)**

(74) Representative: **Ibbotson, Harold**
**Motorola Ltd Patent and Licensing Operations -**
**Europe Jays Close Viables Industrial Estate**
**Basingstoke Hampshire RG22 4PD (GB)**

(56) References cited:
**IEEE JOURNAL OF SOLID-STATE CIRCUITS,**
**vol. SC-15, no. 4, August 1980, NEW YORK**
**(US), S.P. MURARKA et al.: "Refractory silicides**
**of titanium and tantalum for low-resistivity**
**gates and interconnects", pages 474-482**

**APPLIED PHYSICS LETTERS, vol. 36, no. 6,**
**March 1980, NEW YORK (US), M. WITTMER:**
**"TiN and TaN as diffusion barriers in**
**metallizations to silicon semiconductor**
**devices", pages 456-458**

## Description

### Technical Field

This invention relates to metallization systems for semiconductor devices and, more particularly, to the structure, composition and formation of a composite metallization having low resistivity, good thermal and chemical stability, and protective properties for use with devices and integrated circuits, especially very large scale integrated circuits.

### Background of the Invention

There is an ongoing desire to realize semiconductor devices and integrated circuits able to operate at higher speed, complexity, and power density. Heretofore, the achievable performance has been typically limited by the geometry and doping profiles of the various active semiconductor regions necessary for the device or circuit functions. Improvements have been made principally by scaling down the size of these active regions. Silicon based power devices operating at gigahertz frequencies and large scale integrated circuits containing in excess of a hundred thousand active devices are examples of the current state of the art. As used herein "device" refers to single devices or multiple devices commonly referred to as integrated circuits. A device may have two or more terminals and consist of semiconductor regions, dielectric regions and/or metal regions.

Device theory predicts that further improvements in speed and complexity can be achieved by further scaling to smaller dimensions. However, it has been discovered that interconnect and contact metallization resistance has now become a significant factor in limiting device and circuit performance in scaled structures. Series "metallization" resistance is particularly a concern where polycrystalline semiconductor materials are employed for device electrodes and device interconnects, as in very large scale integrated (VLSI) and ultra-high frequency (UHF) structures employing metal-oxide-semiconductor (MOS) devices. As used herein, "metallization" refers to the conductive materials employed for contacting or interconnecting semiconductor devices or other circuit elements whether formed from metals, semiconductors, intermetallic compounds or combinations or composites thereof. As used herein, "poly" refers to polycrystalline materials, typically polycrystalline semiconductors. For example, poly-silicon denotes polycrystalline silicon. Further, "intermetallic" as used herein refers to conductive compounds which have resistivity substantially intermediate between metals and semiconductors and which are formed of one or more substantially metallic elements plus another element. For example, compounds such as metal borides, carbides, nitrides and silicides provide numerous intermetallics.

Doped polycrystalline silicon is much used for metallization purposes despite its relatively high resistivity (typically 1000 µohm-cm) because of its many other favorable and convenient properties. It is well known that series resistance of poly-silicon contact or interconnect metallization layers can be reduced by combining them with or replacing them by lower resistivity intermetallic compounds such as intermetallic metal-silicides. A wide range of elements can form potentially useful silicides. Titanium-silicide is a particularly attractive candidate because its resistivity (approximately 20 µohm-cm) is very much less than polycrystalline silicon and it appears to be compatible in other ways with silicon device processing requirements. An extensive discussion of the properties of various metallic-silicides and particularly titanium-silicide for use in semiconductor devices and circuits is given by S.P. Murarka, "Refractory Silicides for Integrated Circuits", Journal of Vacuum Science and Technology, July/August 1980, pages 775—792, and by S.P. Murarka and D.B. Fraser, "Silicide Formation in Thin Co-sputtered (Titanium and Silicon) Films on Polycrystalline Silicon and $SiO_2$", Journal of Applied Physics, Volume 51, January 1980, pages 350—356.

From Journal of Applied Physics, Volume 36, March 1980, pages 456—458, it is known to use TiN as a diffusion barrier in a composite metallization structure of Cr and Ni.

Several major difficulties are encountered when an intermetallic metal silicide such as titanium-silicide is introduced into a device or integrated circuit structure. First, the substances which etch the silicide also etch oxide layers or poly-silicon layers present on the device, making it extremely difficult to achieve uniform delineation of fine geometries across large wafer areas without damage to other material regions. Second, the silicide layers are in tension so that during subsequent thermal cycles a ridge or "beak" forms at the edge of the silicide region which is difficult to bridge. This leads to open circuits or short circuits in superposed dielectric and metal layers. Thirdly, most silicides react on exposure to hot oxidizing atmospheres encountered in subsequent device processing and form higher resistivity or insulating layers which can negate the purpose to reduce series and contact resistance.

Various pattern forming techniques such as wet chemical etching, dry (plasma) etching, and lift-off pattern generation have been tried or considered for use with silicides, but without sufficient success for practical application. Thus, fine geometry, low resistivity, stable metallization layers compatible with subsequent device or circuit processing steps have yet to be achieved.

From US—A—4 227 944 a semiconductor device having a composite metallization structure is known, which comprises a first layer of conductive metallic material (Mo) on a portion of said device and a second layer of protective intermetallic material (MoSi), said second layer covering said first layer for providing a protective cap.

Accordingly it is an object of this invention to provide an improved contact and interconnection metallization structure for use on semiconductor devices and integrated circuits, particularly silicon MOS—VLSI circuits.

It is a further object of this invention to provide an improved contact and interconnect metallization structure for semiconductor devices and circuits, having lower resistivity to the flow of electrical currents.

It is an additional object of this invention to provide a metallization structure with improved resistance to etching and oxidation, and improved mechanical properties so as to facilitate subsequent fabrication steps.

It is a further object of this invention to provide a method for the fabrication of an improved metallization system for semiconductor devices and circuits.

It is a still further object of this invention to provide an improved method for the fabrication of a composite metallization system for semiconductor devices and circuits using an improved lift-off technique.

Summary of the Invention

These and other objects and advantages are achieved in accordance with the present invention wherein a composite metallization structure is provided comprising a first superposed conductive intermetallic layer, plus a second superposed conductive and protective intermetallic (cap) layer different from said first layer which facilitates contact to the first layer, inhibits oxidation, provides etch protection, and controls tensile strain.

In a particular embodiment of the invention a base layer which is compatible with the underlying device surface is superposed by said first and second intermetallic layers. On silicon semiconductors, poly-silicon is a preferred base layer, titanium silicide a preferred first intermetallic layer and titanium nitride a preferred second intermetallic layer. The present invention further includes a method for fabricating the desired structure by an improved lift-off technique wherein the desired layers are non-uniform in thickness, being thinner where lift-off separation is to occur.

Brief Description of the Drawings

FIG. 1 shows a simplified, idealized cross-section of a portion of an MOS integrated circuit.

FIG. 2A—C shows a simplified cross-section of the gate region of a single MOS device using a polycrystalline silicon base layer/silicide composite metallization of the prior art.

FIG. 3A—C shows a simplified cross-section of the gate region of a single MOS device using an intermetallic composite metallization of the present invention.

FIG. 4A—H shows a simplified cross-section of a single MOS gate composite metallization during several formation steps of the present invention.

FIG. 5A—B shows a schematic representation of the deposition geometry for producing non-uniform deposits in resist openings on a semiconductor wafer to facilitate lift-off.

Detailed Description of the Preferred Embodiment

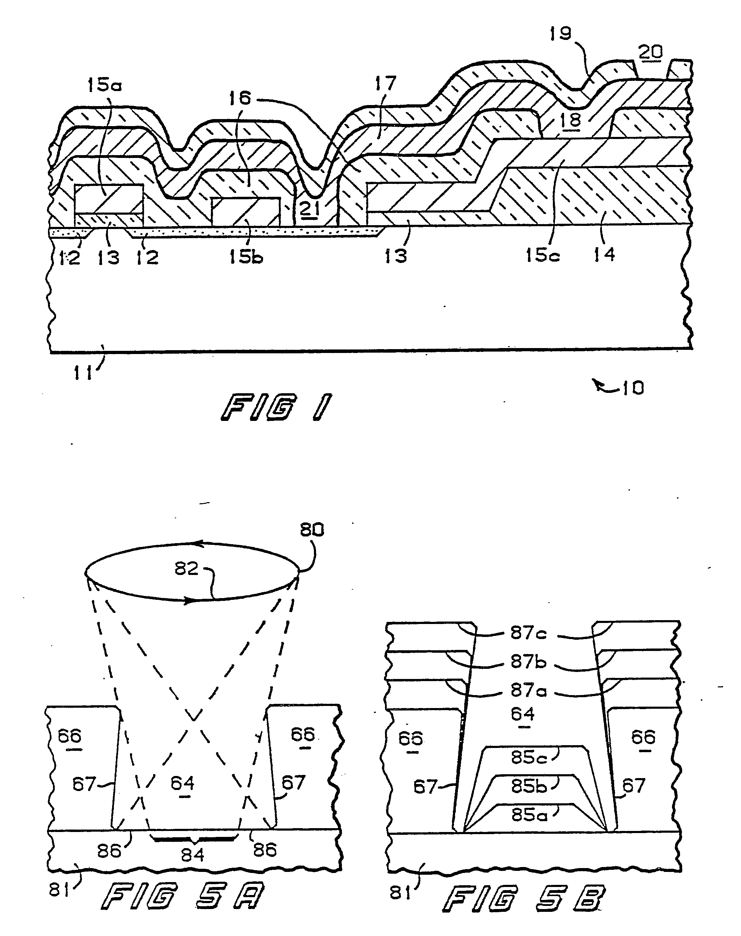

FIG. 1 shows an idealized cross-section of portion 10 of an MOS integrated circuit comprising silicon substrate 11 having diffused regions 12, thin (gate) oxide region 13 and field oxide region 14. Composite first metallization layer 15a—c comprises gate region 15a, contact region 15b, and interconnect region 15c. Dielectric region 16 covers first metallization 15a—c and isolates second metallization layer 17 except at through-holes 18 and 21. Passivation dielectric layer 19 seals and protects the overall structure. External connections (not shown) are made to contact pads in layer 17 exposed through holes 20 in passivation layer 19. The composite metallization of the present invention is useful for any or all of metallizations 15a, 15b, 15c and 17.

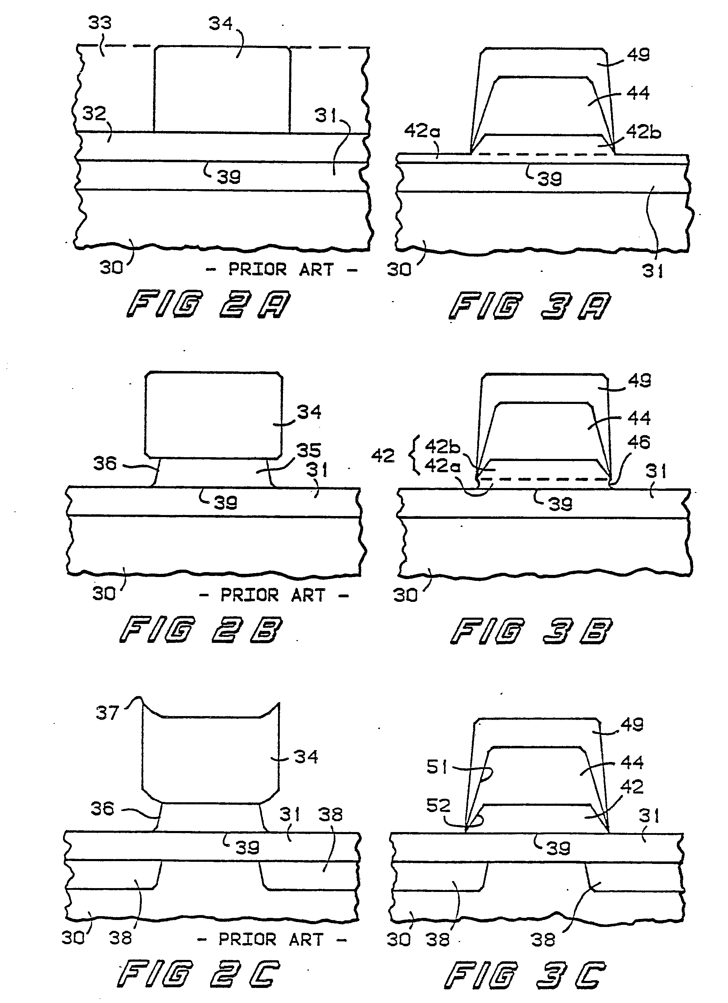

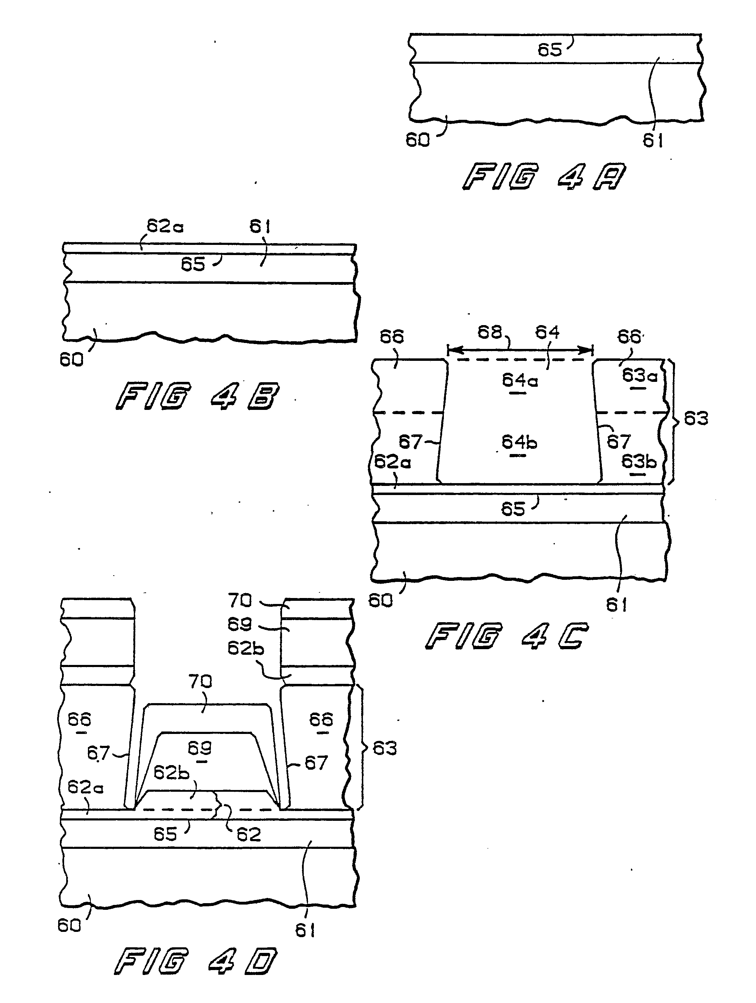

FIG. 2A—C shows a simplified cross-section of the gate region of a single silicon MOS transistor having a composite poly-silicon plus silicide metallization of the prior art, during various stages of processing. In FIG. 2A, silicon substrate 30 has thereon thin gate oxide layer 31, uniform poly-silicon layer 32, and uniform intermetallic silicide layer 33 which is to be etched by any convenient means to form silicide gate region 34. Poly-silicon base layer 32 provides a well characterized and well controlled interface 39 to thin gate oxide layer 31. Additionally, layer 32 should have sufficient thickness to prevent diffusion of material from intermetallic silicide layer 34 to interface 39 with the oxide. Typical prior art thickness values for layer 32 are in the range 100—200 nm. In FIG. 2B, silicide layer 33 and poly-base layer 32 have been preferentially etched so as to form silicide gate region 34 and poly-silicon gate region 35. Under-cut region 36 occurs because poly 32 etches more rapidly than the silicide 33. Use of anisotropic etch techniques such as ion-milling are not practical because they do not stop automatically on reaching oxide layer 31, which is thin (e.g. 30—120 nm) and easily damaged. In FIG. 2C, doped source-drain regions 38 have been formed, typically by ion implantation. When the device undergoes subsequent heat treatment or annealing in the range 700—1200°C, the residual tensile stress present in silicide region 34, produces strain in the form of ridges or "beaks" 37. The combination of undercut 36 and beaks 37 are difficult to bridge, so that when dielectric layer 16 and metallization 17 of FIG. 1 are applied, short circuits or discontinuities occur causing device malfunction.

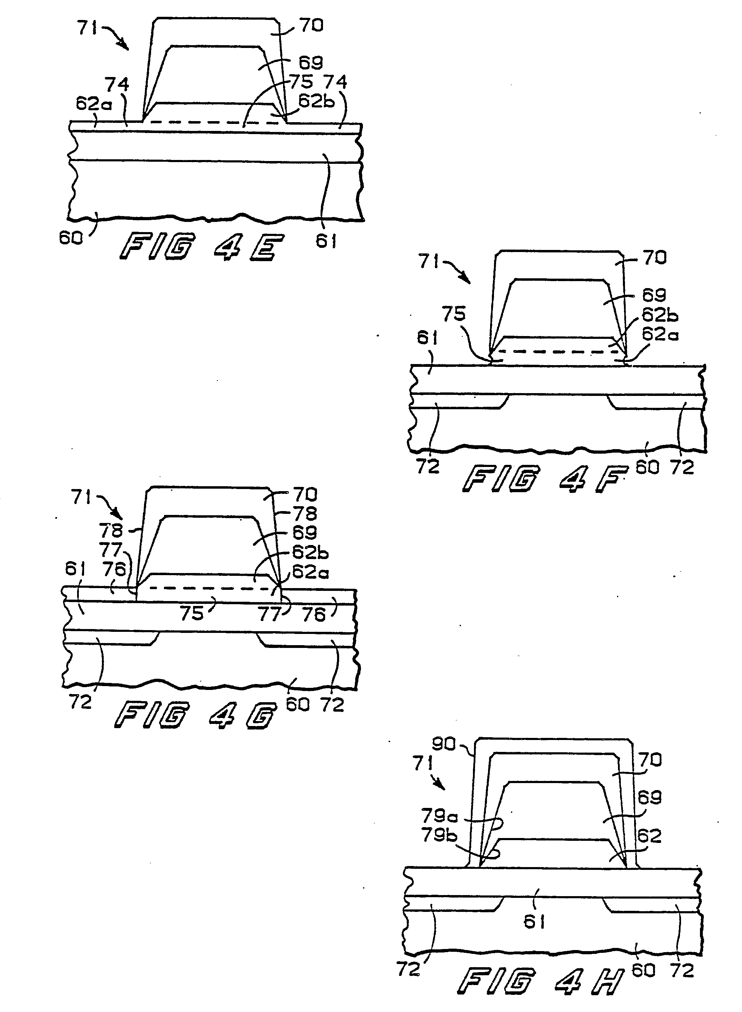

FIGS. 3A—C illustrate a preferred embodiment of an improved surface device structure in accordance with the present invention which avoids the difficulties of the prior art device of FIG. 2. In FIG. 3A, silicon substrate 30 has thereon thin gate oxide layer 31, and optionally, substantially uniform polysilicon base layer 42a to control properties of interface 39 against oxide layer 31. First poly-base layer 42a may be as thin as a few atom layers since it need not act as a diffusion barrier to intermetallic 44. This function is accomplished by thicker second polysilicon base layer 42b which is substantially homogeneous with layer 42a. It will be apparent to those of skill in the art that, while the formation (FIG. 3A—B) of poly layer 42 in two steps consisting of a uniform first base layer 42a surmounted by patterned second base layer 42b may be desirable from the point of view of sealing oxide-poly interface 39 prior to any pattern determining steps, it is not essential and uniform first base layer 42a may be omitted (FIG. 3C).

Poly base layer 42 has thereon first intermetallic silicide layer 44 chosen for its low conductivity and compatibility to underlying semiconductor or dielectric layers, and second intermetallic protective cap 49 chosen for its conductivity and protective properties, e.g., resistance to etching and oxidation, and ability to control tensile strain. As used herein, "protective" refers to the ability of the second intermetallic layer to protect underlying films against oxidizing ambients and etching ambients encountered during subsequent processing of the device or semiconductor wafer being treated by inhibiting these oxidizing or etching reactions, and the ability to control strain to avoid formation of "beaks" and other stress induced surface asperities, whether these effects occur singly or in combination.

Titanium silicide is the preferred choice of material for conductive intermetallic layer 44. However intermetallic silicides of Zr, Hf, V, Nb, Ta, Cr, Mo, W, Fe, Co, Ni, Pt, and Pd are also useful. Of these, Ti, Ta, Mo, and W form silicides having resistivity less than doped poly-silicon and minimum binary eutectic alloy melting temperatures exceeding 1300°C. This is a desirable combination of properties.

Titanium nitride is the preferred choice of material for conductive and protective intermetallic layer 49, although other materials such as tantalum nitride or zirconium nitride can also serve. Titanium nitride has the advantages of being reasonably conductive (approximately 22 μohm-cm) and not readily attacked by buffered HF, HCl, $H_2O_2$—$H_2SO_4$, or halogen bearing liquids or gases. It is also stable with respect to the preferred titanium-silicide up to 1200°C in an oxidizing atmosphere and not degraded by an oxidizing ambient up to 1200°C. Further it is able to provide a diffusion barrier between first intermetallic layer 44 and any subsequent metallization which may be superposed, as for example, aluminum metal as layer 17 of FIG. 1.

FIG. 3B shows the structure following removal of uniform first poly-base layer 42a. Any convenient etching method may be used, such as wet chemical etching, plasma etching, sputtering, ion-milling, or reactive ion etching.

It is desirable to choose a preferential etch such as a chlorine compound which attacks the poly-silicon more rapidly than nitride cap 49 or oxide layer 31. Suitable etchant means are well known in the art. Undercut 46 is minimized (FIG. 2B) by keeping layer 42a thin, or avoided (FIG. 2C) by omitting layer 42a.

In FIG. 3C, doped source-drain regions 38 have been formed as in FIG. 2C, and the device heat treated or annealed at 700—1200°C. No ridges or "beaks" form because protective cap 49 stabilizes silicide layer 44. FIG. 3C illustrates the structure obtained by forming base layer 42 in a single step, omitting uniform first poly-base layer 42a. This substantially eliminates undercutting since cap 49 covers sides 51—52 of first intermetallic 44 and poly-base layer 42. It will be apparent to those of skill in the art that other layers can be added to the structure of FIGS. 3B—C to provide a completed device, as in FIG. 1.

The prior art structure of FIG. 2 has not proven practical for reducing contact and interconnection resistance or semiconductor devices because it has not been possible to find a single intermetallic (e.g. silicide) or poly-base layer plus intermetallic composite with the needed combination of resistivity, etch resistance or selectivity, thermal and chemical stability (e.g. oxidation resistance), mechanical properties (e.g. thermal expansion), and compatibility with the sensitive surfaces and materials inherent in the device structure. The structure illustrated in FIG. 3 avoids the limitations of the prior art by using a multi-layer composite structure wherein the base layer and first intermetallic are chosen to optimize the interface compatibility with the device and to reduce series resistance, while the second intermetallic protective cap is chosen to optimize interactions with subsequent processing steps (etching, oxidation, heat treatment, etc.) and coupling to the external contacts. Additionally the two intermetallics must be mutually compatible metallurgically, chemically, mechanically, and electrically. It has been discovered that for silicon based systems, titanium-silicides and titanium-nitrides form a compatible and preferred set of materials for the first and second intermetallic respectively.

FIG. 4A—H illustrates a preferred method of fabrication of the invented structure for the case of a gate region of a silicon based MOS device. Both FIG. 3 and FIG. 4 are intended as nonlimiting examples. It will be apparent to those of skill in the art that the invented structure and method are useful for forming other contact and interconnect regions and for other semiconductor material combinations.

In FIG. 4A—B, silicon semiconductor wafer 60 has prepared thereon silicon dioxide dielectric layer 61. In this example, layer 61 acts as the gate insulator of an MOS device. Layer 61 is typically 15—150 nm thick, the particular value being chosen by well known methods to give particular electrical characteristics. It is preferred that a cleaning step be performed to insure that oxide interface 65 is free from contaminants. Thin substantially uniform first polycrystalline semiconductor (e.g. silicon) base layer 62a is coated (formed) on oxide layer 61. The thickness of first base layer portion 62a is usually in the range from a few atom layers (0.5—1.0 nm) to several hundred nanometers, preferably in the range 20—30 nm. Layer 62a serves to stabilize interface 65, and may be doped n or p-type to yield specific device characteristics. While first base layer 62a is preferred for the sake of cleanliness, it is not essential and may be omitted.

Pattern forming layer 63 is applied (FIG. 4C) to cover the wafer surface. The wafer surface can include semiconductor regions, oxide or other dielectric regions, metallized regions or combinations thereof. Typically an organic resist having a thickness in the range 0.5 to 2.5 μm, preferably 1 to 1.5 μm, is applied and patterned to give open region (hole portion) 64 and protected regions (lift-off portion) 66. The hole portion open regions penetrate to the underlying wafer surface and correspond in size and shape substantially to the circuit, device or interconnect areas where metallization is desired to be formed. Width 68 of hole portion 64 substantially determines the width of the finished metallization pattern.

It is preferred but not essential that side wall faces 67 of opening 64 be vertical or slope outward, away from the opening. Inward sloping (toward the opening) of faces 67 by more than 10—15° with respect to the surface normal should be avoided. Techniques for forming dielectric layer 61, uniform first poly-base layer 62a and resist layer 63, for cleaning interface 65, and for patterning resist layer 63 to form open regions (hole portion) 64 and closed regions (lift-off portion) 66 are well known per se in the art. Conventional positive photoresist gives faces 67 which typically have an inward sloping angle of 10—15° with respect to the surface normal. This is satisfactory, but less desirable than vertical or outward sloping faces which can be obtained by utilizing two superposed layers of resist 63a and 63b having slightly different sensitivity or solubility so that region 64b opens more than 64a. Only one pattern exposure step is required.

In FIG. 4D, second poly base layer portion 62b is applied over the wafer, covering resist regions 66 (lift-off portion) and also forming on the surfaces exposed in opening 64 (hole portion). Thickness in the range 0—200 nm is useful, while 20—30 nm is preferred. The layer may be doped n or p type to yield specific device characteristics. The deposit formed in opening 64 is thinner adjacent to side walls 67, tapering toward substantially zero thickness. Combined polycrystalline base layer 62 formed of first base layer 62a and second base layer 62b in opening 64 should be of sufficient total thickness, in the range less than 300 nm to stabilize interface 65 and inhibit diffusion of other elements from superposed intermetallic layers 69 and 70 during subsequent processing (heating) steps. It has been found that 15 to 60 nm gives good results and is preferred. While it is convenient in maintaining interface cleanliness to form layer 62 in two steps to give layers 62a and 62b, this is not essential. Base layer 62 may be formed entirely of uniform first base layer 62a, entirely of patterned second base layer 62b, or a combination of 62a and 62b. Additionally, while it has been found that poly base layer 62 is desirably present in MOS gate regions because the properties of poly-silicon are well known and controlled, it is not essential. Useful devices, contacts and/or interconnects can be obtained when poly layer 62 is omitted or converted partially or wholly to an intermetallic during subsequent process steps.

First and second intermetallic layer 69 and 70 are deposited over the wafer surface, covering poly base layer 62b (if present) on resist lift-off portions 66 and also forming on the surface exposed in opening (hole portion) 64. The deposits applied, established and/or formed in opening 64 taper toward zero thickness adjacent to side walls 67, so that layer 70 conformally coats layers 69 and 62b in hole portion 64. The thickness of layer 69 is chosen, based on the measured resistivity, to give the desired series resistance. The thicker the layer, the lower the resistance. There is little benefit in using a thickness greater than that required to give the desired resistance in the completed metallization, since thicker layers make formation of fine line geometry more difficult.

Titanium silicide is preferred for first intermetallic layer 69, but silicides of other materials (e.g. Zr, Hf, V, Nb, Ta, Cr, Mo, W, Fe, Co, Ni, Pt and Pd) can also serve. However, some (e.g. Ni, Pt, Pd) will have restricted temperature ranges. The titanium silicide is generally silicon rich with an average composition $TiSi_x$, with x in the range one to five, but the range 2.5 to 3.5 is preferred. For x less than or equal to two, the oxidation resistance was observed to degrade, and for x greater than or equal to four, the sheet resistance increases. Titanium silicide layers having thicknesses in the range 50—500 nm are useful, and 200—400 nm are preferred.

Titanium nitride ($TiN_y$) is the preferred material for second intermetallic protective cap layer 70. A minimum thickness of approximately 20 nm is found to give useful etch resistance, oxidation resistance, and inhibit "beak" formation. Typical thicknesses are in the range 60—80 nm for protective cap 70, but little advantage is gained by increases beyond about 100 nm. A total thickness of layers 62, 69 and 70 in the range 300—600 nm is a useful compromise between the requirements for reasonable sheet resistance, for example, approximately one ohm per square, and the ability to achieve sub-micron line widths. A typical structure utilizing approximately 50 nm of poly-silicon as the base layer, 300 nm of titanium silicide as the first intermetallic layer and 60 nm of titanium nitride as the second intermetallic layer gave composite metallization sheet resistance values of 0.9 to 1.2 ohms per square. This is substantially improved over the values of 20 to 25 ohms per square typically obtained for comparable (total) thicknesses of doped poly alone.

Vacuum deposition is the preferred method of establishing polycrystalline base layer 62b and forming first intermetallic layer 69. Both layers can be prepared during a single pump-down by energizing a silicon source to deposit poly-base layer 62b (if desired) and then co-energizing a titanium source to co-deposit titanium and silicon to form the silicide. This method is particularly flexible and permits the deposition ratio x in the compound TiSi$_x$ to be easily controlled and varied. Other deposition methods such as sputtering may also be used, provided the substrate temperature remains sufficiently low to avoid thermal damage to resist lift-off portion 66 present on the wafer.

Sputtering is the preferred method of forming the titanium nitride, this being carried out in a nitrogen containing atmosphere using a titanium target. It is believed that the composition approximates TiN (e.g. y = 1). Other methods of formation, such as vacuum evaporation can also be used, so long as resist regions 66 are not damaged thereby.

The methods of preparation of layers 62b, 69, and 70 are important since improved lift-off characteristics and protective properties of the structure are obtained by arranging for layers 62b and 69 in opening 64 to be generally convex in shape, tapering toward zero thickness adjacent to side wall faces 67 of resist regions 66. This is accomplished by carrying out the formation of layers 62b and 69 in a vacuum deposition system where the evaporation sources are not fixed coaxially with respect to the axis of the surface normal extending from the center of opening 64. FIG. 5A illustrates a desired geometrical arrangement of a substantially point source 80, wafer substrate 81, and relative motion 82 during evaporation to obtain a tapered deposit in region 64 as a result of the shadowing of evaporation source 80 by the side walls 67 of resist regions 66. It is preferred that relative motion exist between source 80 and substrate 81 so that central portion 84 of opening 64 is substantially constantly exposed to source 80, while side portions 86 are shadowed by side walls 67 during a part of the evaporation step. The relative motion may be rotary, translatory or a combination. A substantially point source is desirable but not essential. A planetary system for rotating substrate 81 relative to. source 80 gave satisfactory results.

FIG. 5B shows schematically profile 85a—c of a cross section of a resulting deposit at different stages of growth or after deposition of successive layers 85a, 85b, and 85c. The cross-section tapers toward zero thickness from the central region toward the edges of the layer near side walls 67. Film thickness values given herein for films produced according to the methods of this invention or used in the invented structure correspond to the "central thickness", i.e., the thickness of central region 85a—c of the layers. Ordinarily the thickness of regions 87a—c and central regions 85a—c will be the same.

While evaporation is preferred, sputtering can also produce tapered deposits because of wall shadowing. Because of the tapered deposits, layer 70 of FIG. 4 conformally coats underlying layers 62b and 69 in opening 64, producing the desired "cap" structure. The tapered structure also provides (FIG. 5B) an easy break line between deposits 87a—c on lift-off portion resist regions 66 and deposits 85a—c in hole portion opening 64 so that lift-off is effected cleanly. This improves manufacturing yield. While a planetary evaporation system was found to give satisfactory results, it will be recognized by those of skill in the art that a wide variety of source-substrate geometries exist, with or without relative motion, that will give deposits having a break or thin region in the deposit on or adjacent to side walls 67, and varying amounts of taper on deposits 85a—c within region 64.

Following formation (FIG. 4D) of layers 69 and 70, lift-off portion resist regions 66 are eliminated or lifted off by dissolution in appropriate solvents well known in the art. Those portions of layers 62b, 69, and 70 lying on resist regions 66 are thereby also lifted-off, leaving desired metallization shape 71 as in FIG. 4E, and exposing those regions 74 of layer 62a which lay under resist lift-off portions 66. FIG. 4F shows the structure after removing portions 74 lying under lift-off portion 66. Portions 74 of layer 62a may be removed by etching using methods well known in the art. No separate masking operation is required since cap layer 70 substantially protects the top and sides of layers 69 and 62b of composite metallization 71. Undercutting into region 75 of layer 62a located under region 62b of metallization 71 is minimized since layer 62a can be made thinner than in the prior art.

Alternatively, region 74 of layer 62a may be removed by converting regions 74 to oxide (e.g. SiO$_2$) regions 76 by, for example, heating the device structure in an oxidizing atmosphere (see FIG. 4G). Intermetallic protective cap layer 70 substantially protects the top and sides of layers 69 and 62b of composite metallization 71 and inhibits oxidation thereon. There is no significant oxidation of region 75 of layer 62a underlying region 62b of FIG. 4G. Oxidation extends substantially to boundary 77 of region 75 underlying surface 78 of region 70. A 50 nm poly-silicon layer is readily oxidized at 900°C in one hour in dry oxygen. Other oxidation means well known in the art can also be used. Oxide regions 76 may be retained as a convenience for use in subsequent processing steps or selectively removed by methods well known in the art, for example, by using a preferential etchant which does not attack the poly-silicon. With this approach there is substantially no undercutting into region 75 of layer 62a in metallization 71.

The structure obtained by forming portion 62b alone is illustrated in FIG. 4H. Protective cap layer 70 substantially covers the top and sides 79a—b of layers 69 and 62. Source-drain diffusions 72 are typically provided by ion implantation using composite metallization 71 as an implant mask, however other means can be used. There is further illustrated in FIG. 4H the provision of dielectric insulating layer 90 formed in conjunction with or subsequent to layer 70 by the same general technique used to form layers 62b, 69 or 70 in FIG. 4A—G. Examples of means and materials for implementing layer 90 are plasma activated chemical vapor deposition or evaporation or sputtering of $SiO_2$, reactive sputtering of silicon in oxygen or nitrogen to produce $SiO_2$ or $Si_3N_4$, or evaporation of silicon followed by oxidation to $SiO_2$. Insulating layer 90 is convenient in subsequent processing steps to avoid shorts to source-drain contacts of MOS devices. $SiO_2$ is a preferred material. The formation and presence of layer 90 does not interfere with the removal of regions 76 previously described.

Composite metallization 71 corresponds to metallization regions 15a—c of FIG. 1, some portions (15a) being formed over gate oxide, some portions (15b) being formed directly on the semiconductor and some (15c) being formed on thick oxide. Conventional and well known processing steps are used to provide regions or layers 12, 13, 14, 16, 17 and 19 and contact regions 18, 20 and 21 of FIG. 1. It is preferred that processing steps for composite metallization of titanium silicides and titanium nitrides include a heating cycle in a non-reducing ambient to temperatures up to 1200°C to sinter or anneal the deposited intermetallic materials to reduce their resistance. This sintering or annealing may be performed at any time during the subsequent processing, but where ion implantation is utilized, the post-implant anneal to remove implant damage conveniently serves to sinter or anneal the intermetallic as well. While the sintering or annealing step may be omitted, lower composite metallization sheet resistance is obtained by sintering/annealing. It has been found that heating the poly-silicon/titanium silicide/titanium nitride composite metallization to 750°C in nitrogen serves to produce low and stable resistance values. Sinter or annealing temperatures for other intermetallics may be readily determined.

While formation of the first intermetallic layer by co-deposition of its elements is the preferred method, it will be recognized that in-situ formation can also be used. In this alternative, an intermetallic creating layer (e.g. Ti) is deposited in the desired metallization areas and reacted in place by heating to form a silicide with a polycrystalline semiconductor base layer or single crystal semiconductor region which lies beneath. A titanium intermetallic creating layer reacts with silicon to form titanium silicides upon heating to temperatures in the range 500—1200°C, with 750—1000°C preferred. Appropriate temperature ranges for other intermetallic creating layers and/or semiconductor combinations can be readily determined. The step of heating to react the intermetallic creating layer to form the corresponding intermetallic may be performed before or after deposition of the second intermetallic layer. A non-oxidizing atmosphere is preferred for reacting prior to deposition of the second intermetallic, and a non-reducing atmosphere is preferred for reacting after deposition of the second intermetallic. Those portions of the intermetallic creating layer overlying non-reactive dielectric areas (e.g. $SiO_2$, $Si_3N_4$) are expected to remain metallic and conductive, and fulfill the same function of providing conductive paths as would the codeposited intermetallic in those same regions.

Similarly, while the process has been illustrated by use of an organic resist as the pattern forming layer, it will be apparent to those of skill in the art, that other materials can be used provided that they can be selectively dissolved to accomplish the removal (lift-off step), without significantly attacking those materials desired to be retained on the surface.

Thus there has been provided by the present invention an improved contact and interconnect metallization structure for semiconductor device and circuits, which has lower resistivity to the flow of electrical current, which has improved resistance to etching and oxidation to facilitate subsequent processing steps, and which avoids formation of ridges or "beaks" of the prior art. There has been further provided by the present invention an improved process for the formation of a composite intermetallic metallization system for semiconductor devices and circuits, particularly by an improved lift-off technique.

While the present invention has been described in terms of particular device structures and material combinations it will be apparent to those of skill in the art that the concepts apply to a wide range of devices and structures, as for example, MOS devices, bipolar devices, unipolar devices, field effect devices, opto devices, thyristors, capacitors, diodes, device contacts, device interconnects, etc., and can employ a wide range of material combinations.

## Claims

1. A semiconductor device having a composite metallization structure comprising:
   a first layer of conductive intermetallic material (44; 69) formed on a portion of said device;
   a second layer of protective and conductive intermetallic material (49; 70) different from said first layer, said second layer covering said first layer for providing a protective cap and facilitating electrical connection to said first layer; and
   wherein the combination of said first and second layer forms said composite metallization.

2. The device of claim 1 wherein said semiconductor device comprises silicon and said first layer consists essentially of silicon combined with a metal selected from the group consisting of Ti, Zr, Hf, V, Nb, Ta, Cr, Mo, W, Fe, Co, Ni, Pt and Pd.

3. The device of claim 2 wherein said first layer consists essentially of silicon combined with a metal selected from the group consisting of Ti, Ta, Mo, and W, and wherein said second layer consists essentially of Ti, Ta or Zr combined with nitrogen.

4. The device of claim 3 wherein said first layer consists essentially of $TiSi_x$ where x is in the range 2.5 to 3.5, and wherein said second layer consists essentially of a compound of titanium and nitrogen.

5. The device of claim 4 wherein said first layer is non-uniform in thickness, having a cross-section which tapers toward zero thickness from a central region of the cross-section toward the edges of the cross-section of the layer.

6. The semiconductor device of claim 5 further comprising a base layer of polycrystalline semiconductor material formed on a portion of said device, under a portion of said first layer of conductive intermetallic material; and

wherein said first layer of conductive intermetallic material has a resistivity lower than said polycrystalline semiconductor material.

7. A process for fabricating a composite metallization for semiconductor devices comprising:

providing a semiconductor wafer having a major surface containing areas to be contacted by said composite metallization;

coating said major surface with a first polycrystalline semiconductor base layer (62a);

covering said first base layer with a pattern forming layer (63);

patterning said pattern forming layer to provide a hole portion (64) and a lift-off portion (66), said hole portion comprising openings substantially coincident with said areas to be contacted and having side walls penetrating to said first base layer, and said lift-off portion corresponding substantially to areas not to be contacted;

applying a second polycrystalline semiconductor base layer (62b) in said hole portion and over said lift-off portion of said pattern forming layer;

establishing a first intermetallic conductive layer on said second base layer;

forming a second intermetallic conductive and protective layer (70) different from said first intermetallic layer on said first intermetallic layer;

lifting-off said lift-off portion of said pattern forming layer and first superposed portions thereon of said second base layer, said first intermetallic layer and said second intermetallic layer;

exposing as a result of said removing step, portions of said first base layer substantially underlying said lift-off portion;

removing said exposed portion of said first base layer;

leaving intact on said major surface a second superposed portion of said first and second base layer, and first and second intermetallic layers corresponding substantially to said hole portion, said second superposed portion forming a composite;

heating and cooling said composite to anneal, said heated and cooled composite comprising said composite metallization; and

wherein said applying and establishing steps comprise non-uniformly applying and establishing said second base layer and first intermetallic layer so that in said hole portion, said second base layer and first intermetallic layer have a cross-section which tapers toward zero thickness in directions from a central region of said hole portion toward said side walls of said hole portion.

8. A process for fabricating a composite metallization for semiconductor devices comprising:

providing a semiconductor wafer having a major surface containing areas to be contacted by said composite metallization;

covering said major surface with a pattern forming layer;

patterning said pattern forming layer to provide a hole portion and a lift-off portion, said hole portion comprising openings substantially coincident with said areas to be contacted and having side walls penetrating to said major surface, and said lift-off portion corresponding substantially to areas not to be contacted;

applying a polycrystalline semiconductor base layer in said hole portion and over said lift-off portion of said pattern forming layer;

establishing a first intermetallic conductive layer on said base layer;

forming a second intermetallic conductive and protective layer different from said first intermetallic layer on said first intermetallic layer;

lifting-off said lift-off portion of said pattern forming layer and first superposed portion thereon of said base layer, said first intermetallic layer and said second intermetallic layer;

leaving intact on said major surface a second superposed portion of said base layer, and first and second intermetallic layers corresponding substantially to said hole portion, said second superposed portion forming a composite;

heating and cooling said composite to anneal, said heated and cooled composite comprising said composite metallization; and

wherein said applying and establishing steps comprise non-uniformly applying and establishing said base layer and first intermetallic layer so that in said hole portion, said base layer and first intermetallic layer have a cross section which tapers toward zero thickness in directions from a central region of said hole portion toward said side walls of said hole portion.

9. A process for fabricating a composite metallization for semiconductor device comprising:

providing a semiconductor wafer having a major surface containing areas to be contacted by said composite metallization;

covering said major surface with a pattern forming layer;

patterning said pattern forming layer to provide a hole portion and a lift-off portion, said hole portion comprising openings substantially coincident with said areas to be contacted and having side walls penetrating to said major surface, and said lift-off portion corresponding substantially to areas not to be contacted;

establishing a first intermetallic conductive layer in said hole portion and over said lift-off portion of said pattern forming layer;

forming a second intermetallic conductive and protective layer different from said first intermetallic layer on said first intermetallic layer;

lifting-off said lift-off portion of said pattern forming layer and first superposed portions thereon of said first and second intermetallic layer;

leaving intact on said major surface a second superposed portion of said first and second intermetallic layers corresponding substantially to said hole portion, said second superposed portion forming a composite;

heating and cooling said composite to anneal, said heated and cooled composite comprising said composite metallization; and

wherein said establishing step comprises non-uniformly establishing said first intermetallic layer so that in said hole portion, said first intermetallic layer has a cross-section which tapers toward zero thickness in directions from a central region of said hole portion toward said side walls of said hole portion.

10. A process for fabricating a composite metallization for semiconductor devices comprising:

providing a semiconductor wafer having a major surface containing areas to be contacted by said composite metallization;

coating said major surface with a first polycrystalline semiconductor base layer;

covering said first base layer with a pattern forming layer;

patterning said pattern forming layer to provide a hole portion and a lift-off portion, said hole portion comprising openings substantially coincident with said areas to be contacted and having side walls penetrating to said first base layer, and said lift-off portion corresponding substantially to areas not to be contacted;

applying a second polycrystalline semiconductor base layer in said hole portion and over said lift-off portion of said pattern forming layer;

establishing a first intermetallic creating layer on said second base layer;

forming a second intermetallic conductive and protective layer different from said first intermetallic creating layer on said first intermetallic creating layer;

lifting-off said lift-off portion of said pattern forming layer and first superposed portions thereon of said second base layer, said first intermetallic creating layer and said second intermetallic layer;

exposing as a result of said removing step, portions of said first base layer substantially underlying said lift-off portion;

removing said exposed portion of said first base layer;

leaving intact on said major surface a second superposed portion of said first and second base layer, and first intermetallic creating layer and second intermetallic layer corresponding substantially to said hole portion, said second superposed portion forming a composite;

heating and cooling said composite to react said first intermetallic creating layer with portions of said second base layer to produce a first conductive intermetallic layer and thereby forming with said second intermetallic layer and said first base layer said composite metallization; and

wherein said applying and establishing steps comprise non-uniformly applying and establishing said second base layer and first intermetallic creating layer so that in said hole portion, said second base layer and first intermetallic creating layer have a cross-section which tapers toward zero thickness in directions from a central region of said hole portion toward said side walls of said hole portion.

11. A process for fabricating a composite metallization for semiconductor devices comprising:

providing a semiconductor wafer having a major surface containing areas to be contacted by said composite metallization;

covering said major surface with a pattern forming layer;

patterning said pattern forming layer to provide a hole portion and a lift-off portion, said hole portion comprising openings substantially coincident with said areas to be contacted and having side walls penetrating to said major surface, and said lift-off portion corresponding substantially to areas not to be contacted;

applying a polycrystalline semiconductor base layer in said hole portion and over said lift-off portion of said pattern forming layer;

establishing a first intermetallic creating layer on said base layer;

forming a second intermetallic conductive and protective layer different from said first intermetallic creating layer on said first intermetallic creating layer;

lifting-off said lift-off portion of said pattern forming layer and first superposed portion thereon of said base layer, said first intermetallic creating layer and said second intermetallic layer;

leaving intact on said major surface a second superposed portion of said base layer, first intermetallic creating layer and second intermetallic layer corresponding substantially to said hole portion, said second superposed portion forming a composite;

heating and cooling said composite to react said first intermetallic creating layer with portions of said base layer to produce a first conductive intermetallic layer and thereby forming with said second intermetallic layer said composite metallization; and

wherein said applying and establishing steps comprise non-uniformly applying and establishing said base and first intermetallic creating layer so that in said hole portion, said base and first intermetallic creating layer have a cross-section which tapers toward zero thickness in directions from a central region of said hole portion toward said side walls of said hole portion.

12. A process for fabricating a composite metallization for semiconductor devices comprising:

providing a semiconductor wafer having a major surface containing areas to be contacted by said composite metallization;

covering said major surface with a pattern forming layer;

patterning said pattern forming layer to provide a hole portion and a lift-off portion, said hole portion comprising openings substantially coincident with said areas to be contacted and having side walls penetrating to said major surface, and said lift-off portion corresponding substantially to areas not to be contacted;

establishing a first conductive intermetallic creating layer in said hole portion and over said lift-off portion of said pattern forming layer;

forming a second intermetallic conductive and protective layer different from said first intermetallic creating layer on said first intermetallic creating layer;

lifting-off said lift-off portion of said pattern forming layer and first superposed portions thereon of said first intermetallic creating layer and said second intermetallic layer;

leaving intact on said major surface a second superposed portion of said first intermetallic creating layer and said second intermetallic layer corresponding substantially to said hole portion, said second superposed portion forming a composite;

heating and cooling said composite to react said first intermetallic creating layer with portions of said surface to produce a first conductive intermetallic whereby said first intermetallic creating layer and said first and second intermetallics comprise said composite metallization; and

wherein said establishing step comprises non-uniformly establishing said first intermetallic creating layer so that in said hole portion, said first intermetallic creating layer has a cross-section which tapers toward zero thickness in directions from a central region of said hole portion toward said side walls of said hole portion.


**Patentansprüche**

1. Halbleitervorrichtung mit einer Mehrschichtenmetallisierung, enthaltend:

eine erste Schicht aus leitfähigem intermetallischen Material (44; 69), die auf einem Teil der Vorrichtung ausgebildet ist;

eine zweite Schicht aus einem schützenden und leitfähigen intermetallischen Material (49; 70), die sich von der ersten Schicht unterscheidet, wobei die zweite Schicht die erste Schicht bedeckt, um eine schützende Kappe zu bilden und eine elektrische Verbindung zur ersten Schicht zu erleichtern; und

wobei die Kombination aus erster und zweiter Schicht eine Verbundmetallisierung bildet.

2. Vorrichtung nach Anspruch 1, bei der die Halbleitervorrichtung Silicium enthält und die erste Schicht im wesentlichen aus Silicium verbunden mit einem Metall besteht, das aus der Gruppe aus Ti, Zr, Hf, V, Nb, Ta, Cr, Mo, W, Fe, Co, Ni, Pt und Pd besteht.

3. Vorrichtung nach Anspruch 2, bei der die erste Schicht im wesentlichen aus Silicium verbunden mit einem Metall besteht, das aus der Gruppe ausgewählt ist, die aus Ti, Ta, Mo und W besteht und wobei die zweite Schicht im wesentlichen aus Ti, Ta oder Zr verbunden mit Stickstoff besteht.

4. Vorrichtung nach Anspruch 3, bei der die erste Schicht im wesentlichen aus $TiSi_x$ besteht, wobei x im Bereich zwischen 2,5 und 3,5 liegt, und bei der die zweite Schicht im wesentlichen aus einer Verbindung aus Titan und Stickstoff besteht.

5. Vorrichtung nach Anspruch 4, bei der die erste Schicht eine ungleichmäßige Dicke aufweist, die einen Querschnitt hat, die von einem Mittenbereich des Querschnitts gegen die Ränder des Querschnitts der Schicht in Richtung auf eine Nulldicke hin abnimmt.

6. Halbleitervorrichtung nach Anspruch 5, weiterhin enthaltend eine Grundschicht aus einem polykristallinen Halbleitermaterial, die auf einem Abschnitt der Vorrichtung angeordnet ist, unter einem Abschnitt der ersten Schicht des leitfähigen intermetallischen Materials; und

bei der die erste Schicht aus leitfähigem intermetallischen Material einen Widerstand aufweist, der geringer ist, als der des polykristallinen Halbleitermaterials.

7. Verfahren zum Herstellen einer Verbundmetallisierung für eine Halbleitervorrichtung, bestehend aus:

Bereitstellen eines Halbleiterplättchens mit einer Hauptfläche, die mit der Verbundmetallisierung zu kontaktierende Bereiche enthält;

Beschichten der Hauptfläche mit einer ersten polykristallinen Halbleitergrundschicht (62a);

Bedecken der ersten Grundschicht mit einer musterbildenden Schicht (63);

Ausbilden eines Musters in der musterbildenden Schicht zur Erzeugung eines Lochbereiches (64) und eines Lift-Off-Bereiches (66), wobei der Lochbereich Öffnungen aufweist, die im wesentlichen mit den zu kontaktierenden Bereichen zusammenfallen und Seitenwände aufweisen, die bis zur ersten Grundschicht reichen, und der Lift-Off-Bereich im wesentlichen den nicht zu kontaktierenden Bereichen entspricht;

Aufbringen einer zweiten polykristallinen Halbleitergrundschicht (62b) in den Lochbereich und über den Lift-Off-Bereich der musterbildenden Schicht;

Herstellen einer ersten intermetallischen leitfähigen Schicht auf der zweiten Grundschicht;

Ausbilden einer zweiten intermetallischen leitfähigen und schützenden Schicht (70) auf der ersten intermetallischen Schicht, die unterschiedlich zu der ersten intermetallischen Schicht ist;

Entfernen des Lift-Off-Bereiches der musterbildenden Schicht und der ersten überlagerten Bereiche darauf der zweiten Grundschicht, der ersten intermetallischen Schicht und der zweiten intermetallischen Schicht;

als Ergebnis des Entfernungsvorgangs, Belichten von Bereichen der ersten Grundschicht, die im wesentlichen unter dem Lift-Off-Bereich liegen;

Entfernen des belichteten Bereiches der ersten Grundschicht;

auf der Hauptfläche Unversehrtlassen eines zweiten überlagerten Bereiches der ersten und zweiten Grundschicht und der ersten und zweiten intermetallischen Schichten, der im wesentlichen dem Lochbereich entspricht, wobei der zweite überlagerte Abschnitt einen Verbund bildet;

Aufheizen und Kühlen des Verbundes zum Zwecke des Anlassens, wobei der aufgeheizte und abgekühlte Verbund die Verbundmetallisierung enthält; und

wobei die Zuführ- und Einrichtungsschritte enthalten das ungleichförmige Zuführen und Einrichten der zweiten Grundschicht und der ersten intermetallischen Schicht derart, daß in dem Lochbereich die zweite Grundschicht und die erste intermetallische Schicht einen Querschnitt aufweisen, der von einem Mittenbereich des Lochbereichs gegen die Seitenwände des Lochbereiches gegen eine Nulldicke abnimmt.

8. Verfahren zum Herstellen einer Verbundmetallisierung für Halbleitervorrichtungen, enthältend:

Bereitstellen eines Halbleiterplättchens mit einer Hauptoberfläche, die mit der Verbundmetallisierung zu kontaktierende Bereiche enthält;

Bedecken der Hauptoberfläche mit einer musterbildenden Schicht;

Ausbilden eines Musters in der musterbildenden Schicht, um einen Lochbereich und einen Lift-Off-Bereich auszubilden, wobei der Lochbereich Öffnungen aufweist, die im wesentlichen mit den zu kontaktierenden Bereichen zusammenfallen und Seitenwände aufweisen, die bis auf die Hauptoberfläche reichen, und der Lift-Off-Bereich im wesentlichen den nicht zu kontaktierenden Flächen entspricht;

Aufbringen einer polykristallinen Halbleitergrundschicht in den genannten Lochbereich und über den Lift-Off-Bereich der musterbildenden Schicht;

Einrichten einer ersten intermetallischen leitfähigen Schicht auf der Grundschicht;

Ausbilden einer zweiten intermetallischen und schützenden Schicht auf der ersten intermetallischen Schicht, die sich von der ersten intermetallischen Schicht unterscheidet;

Entfernen des Lift-Off-Bereiches der musterbildenden Schicht und des ersten überlagerten Bereiches darauf der Grundschicht, der ersten intermetallischen Schicht und der zweiten intermetallischen Schicht;

auf der Hauptoberfläche Unberührtlassen eines zweiten überlagerten Bereiches der Grundschicht und der ersten und zweiten intermetallischen Schichten, der im wesentlichen dem Lochbereich entspricht, wobei der zweite überlagerte Bereich einen Verbund bildet;

Aufheizen und Abkühlen des Verbundes zum Zwecke des Anlassens, wobei der aufgeheizte und abgekühlte Verbund die Verbundmetallisierung enthält; und

wobei die Aufbringungs- und Einrichtungsschritte das ungleichförmige Aufbringen und Einrichten der Grundschicht und der ersten intermetallischen Schicht derart enthalten, daß der Lochbereich, die Grundschicht und die erste intermetallische Schicht einen Querschnitt aufweisen, der in Richtungen von einem Mittenbereich des Lochbereiches gegen die genannten Seitenwände des Lochbereiches gegen eine Nulldicke abnimmt.

9. Verfahren zum Herstellen einer Verbundmetallisierung für Halbleitervorrichtungen, enthaltend:

Bereitstellen eines Halbleiterplättchens mit einer Hauptoberfläche, die mit der Verbundmetallisierung zu kontaktierende Flächen enthält;

Bedecken der Hauptoberfläche mit einer musterbildenden Schicht;

Ausbilden eines Musters in der musterbildenden Schicht zum Erzeugen eines Lochbereiches und eines Lift-Off-Bereiches, wobei der Lochbereich Öffnungen aufweist, die im wesentlichen mit den zu kontaktierenden Flächen zusammenfallen und Seitenwände aufweisen, die bis zu der Hauptoberfläche reichen, und der Lift-Off-Bereich im wesentlichen den nicht zu kontaktierenden Flächen entspricht;

Einrichten einer ersten intermetallischen leitfähigen Schicht in dem Lochbereich und über den Lift-Off-Bereich der musterbildenden Schicht;

Ausbilden einer zweiten intermetallischen leitfähigen und schützenden Schicht auf der ersten intermetallischen Schicht, die sich von der ersten intermetallischen Schicht unterscheidet;

Entfernen des Lift-Off-Bereiches der musterbildenden Schicht und ersten überlagerten Bereichen darauf der ersten und zweiten intermetallischen Schicht;

auf der Hauptoberfläche Unversehrtlassen eines zweiten überlagerten Bereiches der ersten und zweiten intermetallischen Schichten, der im wesentlichen dem Lochbereich entspricht, wobei der zweite überlagerte Bereich einen Verbund bildet;

Aufheizen und Abkühlen des Verbundes zum Zwecke des Anlassens, wobei der aufgeheizte und abgekühlte Verbund die Verbundmetallisierung enthält; und

wobei der Einrichtungsschritt das ungleichförmige Einrichten einer ersten intermetallischen Schicht derart enthält, daß in dem Lochbereich die erste intermetallische Schicht einen Querschnitt aufweist, der in Richtungen von einem Mittenbereich des Lochbereiches gegen die Seitenwände des Lochbereiches auf eine Nulldicke hin abnimmt.

10. Verfahren zum Herstellen einer Verbundmetallisierung für Halbleitervorrichtungen, enthaltend:

Bereitstellen eines Halbleiterplättchens mit einer Hauptoberfläche, die mit der Verbundmetallisierung zu kontaktierende Flächen enthält;

Beschichten der Hauptoberfläche mit einer ersten polykristallinen Halbleitergrundschicht;

Bedecken der ersten Grundschicht mit einer musterbildenden Schicht;

Ausbilden eines Musters in der musterbildenden Schicht, um einen Lochbereich und einen Lift-Off-Bereich auszubilden, wobei der Lochbereich Öffnungen enthält, die im wesentlichen mit den zu kontaktierenden Flächen zusammenfallen und Seitenwände aufweisen, die bis zur ersten Grundschicht reichen, und der Lift-Off-Bereich im wesentlichen den nicht zu kontaktierenden Flächen entspricht;

Aufbringen einer zweiten polykristallinen Halbleitergrundschicht in den Lochbereich und über den Lift-Off-Bereich der musterbildenden Schicht;

Einrichten einer ersten intermetallischen Erzeugerschicht auf der zweiten Grundschicht;

Ausbilden einer zweiten intermetallischen leitenden und schützenden Erzeugerschicht, die von der ersten intermetallischen Erzeugerschicht verschieden ist;

Entfernen des Lift-Off-Bereiches der musterbildenden Schicht und der ersten überlagerten Bereiche darauf der zweiten Grundschicht, der ersten intermetallischen Erzeugerschicht und der zweiten intermetallischen Schicht;

als Ergebnis des Entfernungsschritts, Belichten von Bereichen der ersten Grundschicht, die im wesentlichen unter dem Lift-Off-Bereich liegen;

Entfernen des belichteten Bereiches der ersten Grundschicht;

auf der Hauptoberfläche Unversehrtlassen eines zweiten überlagerten Bereiches der ersten und zweiten Grundschicht, und der ersten intermetallischen Erzeugerschicht und der zweiten intermetallischen Schicht, der im wesentlichen dem Lochbereich entspricht, wobei der zweite überlagerte Bereich einen Verbund bildet;

Aufheizen und Abkühlen des Verbundes, um die erste intermetallische Erzeugerschicht mit Bereichen der zweiten Grundschicht zu reagieren, um eine erste leitfähige intermetallische Schicht zu erzeugen und dadurch mit der zweiten intermetallischen Schicht und der ersten Grundschicht die Verbundmetallisierung auszubilden; und

wobei die Aufbringungs- und Einrichtungsschritte das ungleichförmige Aufbringen und Einrichten der zweiten Grundschicht und der ersten intermetallischen Erzeugerschicht enthalten derart, daß in dem Lochbereich die zweite Grundschicht und die erste intermetallische Erzeugerschicht einen Querschnitt aufweisen, der in Richtungen von einem Mittenbereich des Lochbereiches gegen die Seitenwände des Lochbereiches gegen eine Nulldicke hin abnimmt.

11. Verfahren zum Herstellen einer Verbundmetallisierung für Halbleitervorrichtungen, enthaltend:

Bereitstellen eines Halbleiterplättchens mit einer Hauptoberfläche, die mit der Verbundmetallisierung zu bedeckende Flächen enthält;

Bedecken der Hauptoberfläche mit einer musterbildenden Schicht;

Ausbilden eines Musters in der musterbildenden Schicht, um einen Lochbereich und einen Lift-Off-Bereich zu erzeugen, wobei der Lochbereich Öffnungen enthält, die im wesentlichen mit den zu kontaktierenden Flächen zusammenfallen und Seitenwände aufweisen, die bis auf die Hauptoberfläche reichen, und der Lift-Off-Bereich im wesentlichen den nicht zu kontaktierenden Flächen entspricht;

Aufbringen einer polykristallinen Halbleitergrundschicht in den Lochbereich und über den Lift-Off-Bereich der musterbildenden Schicht;

Einrichten einer ersten intermetallischen Erzeugerschicht auf der Grundschicht;

Ausbilden einer zweiten intermetallischen leitfähigen und schützenden Schicht auf der ersten intermetallischen Erzeugerschicht, die sich von der ersten intermetallischen Erzeugerschicht unterscheidet;

Entfernen des Lift-Off-Bereiches und des ersten überlagerten Bereiches darauf von der Grundschicht, der ersten intermetallischen Erzeugerschicht und der zweiten intermetallischen Schicht;

auf der Hauptoberfläche Unberührtlassen eines zweiten überlagerten Bereiches der Grundschicht, der ersten intermetallischen Erzeugerschicht und der zweiten intermetallischen Erzeugerschicht entsprechend im wesentlichen dem Lochbereich, wobei der zweite überlagerte Bereich einen Verbund bildet;

Aufheizen und Abkühlen des Verbundes, um die erste intermetallische Erzeugerschicht mit Bereichen der ersten Grundschicht zu reagieren, um eine erste leitfähige intermetallische Schicht zu erzeugen und dadurch mit der zweiten intermetallischen Schicht die Verbundmetallisierung auszubilden; und

wobei die Aufbringungs- und Einrichtungsschritte das ungleichförmige Aufbringen und Einrichten der Grund- und ersten intermetallischen Erzeugerschicht enthalten derart, daß in dem Lochbereich die Grund- und erste intermetallische Erzeugerschicht einen Querschnitt aufweisen, der in Richtungen von einem Mittenbereich des Lochbereiches gegen die Seitenwände des Lochbereiches gegen eine Nulldicke hin abnimmt.

12. Verfahren zum Herstellen einer Verbundmetallisierung für Halbleitervorrichtungen, enthaltend:

Bereitstellen eines Halbleiterplättchens mit einer Hauptoberfläche, die mit der Verbundmetallisierung zu kontaktierende Flächen aufweist;

Bedecken der Hauptoberfläche mit einer musterbildenden Schicht;

Ausbilden eines Musters in der musterbildenden Schicht, um einen Lochbereich und einen Lift-Off-Bereich auszubilden, wobei der Lochbereich Öffnungen aufweist, die im wesentlichen mit den zu kontaktierenden Flächen zusammenfallen und Seitenwände aufweisen, die bis zu der Hauptoberfläche reichen, und der Lift-Off-Bereich im wesentlichen den nicht zu kontaktierenden Flächen entspricht;

Einrichten einer ersten leitfähigen intermetallischen Erzeugerschicht in dem Lochbereich und über den Lift-Off-Bereich der musterbildenden Schicht;

Ausbilden einer zweiten intermetallischen leitfähigen und schützenden Schicht auf der ersten intermetallischen Erzeugerschicht, die sich von der ersten intermetallischen Erzeugerschicht unterscheidet;

Entfernen des Lift-Off-Bereiches der musterbildenden Schicht und der ersten überlagerten Bereiche darauf der ersten intermetallischen Erzeugerschicht und der zweiten intermetallischen Schicht;

auf der Hauptoberfläche Unverletztlassen eines zweiten überlagerten Bereiches der ersten intermetallischen Erzeugerschicht und der zweiten intermetallischen Schicht entsprechend im wesentlichen dem Lochbereich, wobei der zweite überlagerte Bereich einen Verbund bildet;

Aufheizen und Abkühlen des Verbundes, um die erste intermetallische Erzeugerschicht mit Bereichen der Oberfläche zu reagieren, um eine erste leitfähige Intermetallik zu bilden, wodurch die erste intermetallische Erzeugerschicht und die ersten und zweiten Intermetalliken die Verbundmetallisierung bilden; und

wobei der Einrichtungsschritt das ungleichförmige Einrichten der ersten intermetallischen Erzeugerschicht in dem Lochbereich enthält derart, daß die erste intermetallische Erzeugerschicht einen Querschnitt aufweist, der in Richtungen von einem Mittenbereich des Lochbereiches gegen die Seitenwände des Lochbereiches gegen eine Nulldicke hin abnimmt.

**Revendications**

1. Dispositif à semi-conducteur ayant une structure composite de métallisation comprenant:

une première couche d'un matériau intermétallique conducteur (44; 69) formé sur une partie du dispositif;

une seconde couche d'un matériau intermétallique protecteur et conducteur (49, 70), différent de la première couche, la seconde couche recouvrant la première couche afin qu'elle forme une couverture protectrice et facilite la connexion électrique avec la première couche, et

la combinaison de la première et de la seconde couche forme la métallisation composite.

2. Dispositif selon la revendication 1, dans lequel le dispositif à semi-conducteur est formé de silicium et la première couche est formée essentiellement de silicium combiné à un métal choisi dans le groupe qui comprend Ti, Zr, Hf, V, Nb, Ta, Cr, Mo, W, Fe, Co, Ni, Pt et Pd.

3. Dispositif selon la revendication 2, dans lequel la première couche est formée essentiellement de silicium combiné à un métal choisi dans le groupe qui comprend Ti, Ta, Mo et W, et dans lequel la seconde couche est formée essentiellement de Ti, Ta ou Zr combinés avec de l'azote.

4. Dispositif selon la revendication 3, dans lequel la première couche est formée essentiellement de $TiSi_x$, x étant compris entre 2,5 et 3,5, et dans lequel la seconde couche est formée essentiellement d'un composé du titane et de l'azote.

5. Dispositif selon la revendication 4, dans lequel la première couche a une épaisseur non uniforme, ayant une section qui diminue vers une valeur nulle d'une région centrale vers les bords de la section de la couche.

6. Dispositif à semi-conducteur selon la revendication 5, comprenant en outre une couche de base d'un matériau semi-conducteur polycristallin formé sur une partie dudit dispositif, sous une partie de la première couche du matériau intermétallique conducteur, et

dans lequel la première couche du matériau intermétallique conducteur a une résistivité inférieure à celle du matériau semi-conducteur polycristallin.

7. Procédé de fabrication d'une métallisation composite destinée à des dispositifs à semiconducteur comprenant:

la préparation d'une tranche semi-conductrice ayant une grande face comportant des zones qui doivent être mises au contact de la métallisation composite,

le revêtement de cette grande face d'une première couche de base (62a) d'un semi-conducteur polycristallin,

le recouvrement de la première couche de base par une couche (63) destinée à former un dessin,

la formation d'un dessin dans la couche destinée à former un dessin afin qu'une partie (67) formant un trou et une partie (66) de décollement soient réalisées, la partie formant un trou ayant des ouvertures coïncidant pratiquement avec les zones qui doivent être mises en contact et ayant des parois latérales traversant la première couche de base, la partie de décollement correspondant pratiquement aux zones qui ne doivent pas être mises en contact,

l'application d'une seconde couche de base (62b) d'un semi-conducteur polycristallin dans la partie formant un trou et sur la partie de décollement de la couche destinée à former un dessin,

l'établissement d'une première couche conductrice intermétallique sur la seconde couche de base,

la formation d'une seconde couche intermétallique conductrice et protectrice (70) différente de la première couche intermétallique, sur la première couche intermétallique,

le décollement de la partie de décollement de la couche destinée à former un dessin et des premières parties superposées de la seconde couche de base, de la première couche intermétallique et de la seconde couche intermétallique,

l'exposition, à la suite de cette opération d'enlèvement, de parties de la première couche de base placées pratiquement sous la partie de décollement,

l'enlèvement de la partie exposée de la première couche de base,

le maintien à l'état intact, sur ladite grande face, d'une seconde partie superposée de la première et de la seconde couche de base et de la première et de la seconde couche intermétallique correspondant pratiquement à la partie formant un trou, la seconde partie superposée formant une structure composite,

le chauffage et le refroidissement de la structure composite afin qu'elle soit recuite, la structure composite chauffée et refroidie constituant la métallisation composite, et

les opérations d'application et d'établissement comprennent l'application non uniforme et l'établissement de la seconde couche de base et de la première couche intermétallique de manière que, dans la partie formant un trou, la seconde couche de base et la première couche intermétallique aient une section dont l'épaisseur diminue jusqu'à une valeur nulle à partir de la région centrale de la partie formant un trou, vers les parois latérales de cette partie formant un trou.

8. Procédé de fabrication d'une métallisation composite destinée à des dispositifs à semi-conducteur comprenant:

la réalisation d'une tranche semi-conductrice ayant une grande face comprenant des zones destinées à être au contact de la métallisation composite,

le recouvrement de la grande face par une couche destinée à former un dessin,

la formation d'un dessin dans la couche destinée à former un dessin afin qu'une partie formant un trou et une partie de décollement soient réalisées, la partie formant un trou comprenant des ouvertures qui coïncident pratiquement avec les zones qui doivent être en contact et ayant des parois latérales qui traversent jusqu'à la grande face, la partie de décollement correspondant pratiquement aux zones qui ne doivent pas être mises en contact,

l'application d'une couche de base d'un semi-conducteur polycristallin dans la partie formant un trou et sur la partie de décollement de la couche destinée à former un dessin,

l'établissement d'une première couche intermétallique conductrice sur ladite couche de base,

la formation d'une seconde couche intermétallique conductrice et protectrice différente de la première couche intermétallique sur la première couche intermétallique,

le décollement de la partie de décollement de la couche destinée à former un dessin et de la première partie superposée de la couche de base, de la première couche intermétallique et de la seconde couche intermétallique,

le maintien intact, sur ladite grande face, d'une seconde partie superposée de la couche de base et de la première et de la seconde couche intermétallique, correspondant pratiquement à la partie en forme de trou, la seconde partie superposée formant une structure composite,

le chauffage et le refroidissement de la structure composite afin qu'elle soit recuite, la structure composite chauffée et refroidie constituant la métallisation composite, et

l'application et l'établissement comportent une application non uniforme et un établissement de la couche de base et de la première couche intermétallique de manière que, dans la partie en forme de trou, la première couche de base et la première couche intermétallique aient une section dont l'épaisseur diminue jusqu'à une valeur nulle à partir de la région centrale de la partie en forme de trou vers les parois latérales de cette partie.

9. Procédé de fabrication d'une métallisation composite destinée à des dispositifs à semi-conducteur, comprenant:

la réalisation d'une tranche semi-conductrice ayant une grande face comprenant des zones destinées à être mises au contact de la métallisation composite,

le recouvrement de ladite grande face par une couche destinée à former un dessin,

la formation d'un dessin dans la couche destinée à former un dessin afin qu'une partie en forme de trou et une partie de décollement soient réalisées, la partie en forme de trou comprenant des ouvertures coïncidant pratiquement avec les zones destinées à être mises en contact et ayant des parois latérales qui traversent jusqu'à la grande face, la partie de décollement correspondant pratiquement aux zones qui ne doivent pas être mises en contact,

l'établissement d'une première couche intermétallique conductrice dans la partie en forme de trou et sur la partie de décollement de la couche destinée à former un dessin,

la formation d'une seconde couche intermétallique conductrice et protectrice différente de la première couche intermétallique sur cette première couche intermétallique,

le décollement de la partie de décollement de la couche destinée à former un dessin et des premières parties superposées de la première et de la seconde couche intermétallique,

le maintien intact, sur ladite grande face, d'une seconde partie superposée de la première et de la seconde couche intermétallique correspondant pratiquement à la partie en forme de trou, la seconde partie superposée formant une structure composite,

le chauffage et le refroidissement de la structure composite afin qu'elle soit recuite, la structure composite chauffée et refroidie constituant la métallisation composite, et

l'opération d'établissement comprend l'établissement non uniforme de la première couche intermétallique afin que, dans la partie en forme de trou, la première couche intermétallique possède une section dont l'épaisseur diminue vers zéro à partir de la région centrale de la partie en forme de trou, vers les parois latérales de cette partie.

10. Procédé de fabrication d'une métallisation composite destinée à des dispositifs à semi-conducteur, comprenant:

la réalisation d'une tranche semi-conductrice ayant une grande face comprenant des zones destinées à être mises au contact de la métallisation composite, le revêtement de la grande face d'une première couche de base d'un semi-conducteur polycristallin,

le recouvrement de la première couche de base par une couche destinée à former un dessin,

la formation d'un dessin dans la couche destinée à former un dessin afin qu'une partie en forme de trou et une partie de décollement soient formées, la partie en forme de trou comprenant des ouvertures coïncidant pratiquement avec les zones destinées à être en contact et ayant des parois latérales traversant jusqu'à la première couche de base, la partie de décollement correspondant pratiquement aux zones qui ne doivent pas être en contact,

l'application d'une seconde couche de base d'un semi-conducteur polycristallin dans la partie en forme de trou et sur la partie de décollement de la couche destinée à former un dessin,

l'établissement d'une première couche intermétallique de création sur la seconde couche de base,

la formation d'une seconde couche intermétallique conductrice et protectrice, différente de la première couche intermétallique de création, sur cette première couche,

le décollement de la partie de décollement de la couche destinée à former un dessin et des premières parties superposées de la seconde couche de base, de la première couche intermétallique de création et de la seconde couche intermétallique,

l'exposition, à la suite de cette opération d'enlèvement, de parties de la première couche de base qui se trouve pratiquement au-dessous de la partie de décollement,

l'enlèvement de la partie exposée de la première couche de base,

le maintien intact, sur la grande face, d'une seconde partie superposée de la première et de la seconde couche de base, et de la première couche intermétallique de création et de la seconde couche intermétallique correspondant pratiquement à la partie en forme de trou, la seconde partie superposée formant une structure composite,

le chauffage et le refroidissement de la structure composite afin que la première couche intermétallique de création réagisse avec des parties de la seconde couche de base en formant une première couche intermétallique conductrice et en formant ainsi, avec la seconde couche intermétallique et la première couche de base, la métallisation composite, et

les opérations d'application et d'établissement comportent l'application non uniforme et l'établissement de la seconde couche de base et de la première couche intermétallique de création de manière que, dans la partie en forme de trou, la seconde couche de base et la première couche intermétallique de création aient une section qui diminue jusqu'à une épaisseur nulle, de la région centrale de la partie en forme de trou vers les parois latérales de celle-ci.

11. Procédé de fabrication d'une métallisation composite, destinée à des dispositifs à semi-conducteur, comprenant:

la réalisation d'une tranche semi-conductrice ayant une grande face comprenant des zones destinées à être mises au contact de la métallisation composite,

le recouvrement de ladite grande face par une couche destinée à former un dessin,

la formation d'un dessin dans la couche destinée à former un dessin afin qu'une partie en forme de trou et une partie de décollement soient formées, la partie en forme de trou comprenant des ouvertures coïncidant pratiquement avec lesdites zones destinées à être en contact et ayant des parois latérales pénétrant jusqu'à la grande face, la partie de décollement correspondant pratiquement à des zones qui ne doivent pas être mises en contact,

l'application d'une couche de base d'un semi-conducteur polycristallin dans la partie en forme de trou et sur la partie de décollement de la couche destinée à former un dessin,

l'établissement d'une première couche intermétallique de création sur la couche de base,

la formation d'une seconde couche intermétallique conductrice et protectrice différente de la première couche intermétallique de création, sur cette première couche intermétallique de création,

le décollement de la partie de décollement de la couche destinée à former un dessin et de la première partie superposée de la couche de base, de la première couche intermétallique de création et de la seconde couche intermétallique,

le maintien intact, sur la grande face, d'une seconde partie superposée de la couche de base, de la première couche intermétallique de création et de la seconde couche intermétallique correspondant pratiquement à la partie en forme de trou, la seconde partie superposée formant une structure composite,

le chauffage et le refroidissement de la structure composite afin que la première couche intermétallique de création réagisse avec des parties de ladite couche de base avec formation d'une première couche intermétallique conductrice et formation ainsi, avec la seconde couche intermétallique, de la métallisation composite, et

les opérations d'application et d'établissement comportent l'application non uniforme et l'établissement de la couche de base et de la première couche intermétallique de création de manière que, dans la partie en forme de trou, la couche de base et la première couche intermétallique de création aient une section qui diminue jusqu'à une épaisseur nulle de la région centrale de la partie en forme de trou vers les parois latérales de cette partie.

12. Procédé de fabrication d'une métallisation composite destinée à des dispositifs à semi-conducteur comprenant:

la réalisation d'une tranche semi-conductrice ayant une grande face comportant des zones destinées à être au contact de la métallisation composite,

le recouvrement de la grande face par une couche destinée à former un dessin,

la formation d'un dessin dans la couche destinée à former un dessin afin qu'une partie en forme de trou et une partie de soulèvement soient formées, la partie en forme de trou comportant des ouvertures coïncidant pratiquement avec les zones destinées à être en contact et ayant des parois latérales qui traversent jusqu'à la grande face, la partie de décollement correspondant pratiquement à des zones qui ne doivent pas être en contact,

l'établissement d'une première couche intermétallique conductrice de création dans la partie en forme de trou et sur la partie de décollement de la couche destinée à former un dessin,

la formation d'une seconde couche intermétallique conductrice et protectrice différente de la première couche intermétallique de création, sur cette première couche,

le décollement de la partie de décollement de la couche destinée à former un dessin et des premières parties superposées de la première couche intermétallique de création et de la seconde couche intermétallique,

le maintien intact, sur la grande face, d'une seconde partie superposée de la première couche intermétallique de création et de la seconde couche intermétallique correspondant pratiquement à la partie en forme de trou, la seconde partie superposée formant une structure composite,

le chauffage et le refroidissement de la structure composite afin que la première couche intermétallique de création réagisse avec des parties de la surface en formant une première couche intermétallique conductrice, si bien que la première couche intermétallique de création et la première et la seconde couche intermétallique constituent la métallisation composite, et

l'opération d'établissement comprenant l'établissement non uniforme de la première couche intermétallique de création de manière que, dans la partie en forme de trou, la première couche intermétallique de création ait une section dont l'épaisseur diminue d'une région centrale de la partie en forme de trou vers les parois latérales de cette partie.

FIG 1

FIG 5A

FIG 5B

1

FIG 2A — PRIOR ART —

FIG 3A

FIG 2B — PRIOR ART —

FIG 3B

FIG 2C — PRIOR ART —

FIG 3C

2

FIG 4A

FIG 4B

FIG 4C

FIG 4D

FIG 4E

FIG 4F

FIG 4G

FIG 4H